# EUROPEAN PATENT APPLICATION

(11) **EP 4 773 143 A1**
(43) Date of publication of application: **08.07.2026**
(21) Application number: 25187072.1
(22) Date of filing: 02.07.2025
(51) Int. Cl.: G11C 29/02, G11C 29/44, G11C 29/10, G11C 29/46, G11C 29/12, G11C 29/18, G11C 29/36

(54) **STORAGE DEVICE AND OPERATING METHOD THEREOF**

(30) Priority: 07.01.2025 KR 20250002119
(71) Applicant: Samsung Electronics Co., Ltd., Suwon-si, Gyeonggi-do 16677 (KR)
(72) Inventor: KIM, Myungkyu, 16677 Suwon-si (KR); KIM, Minoh, 16677 Suwon-si (KR); SEOK, Junyeong, 16677 Suwon-si (KR)
(74) Representative: Marks & Clerk LLP

(57) **Abstract**

The present disclosure relates to a storage. The storage device includes a storage controller including a first data pin and a first command/address (CA) pin and a memory device including a second data pin connected to the first data pin through a data line and a second CA pin connected to the first CA pin through a CA line. The storage controller is configured to transmit a CA training command to the memory device through the data line to start a CA training operation and a first training pattern to the memory device through the CA line, and the memory device is configured to receive the CA training command through the data line, receive a second training pattern through the CA line when the storage controller transmits the first training pattern, and perform the CA training operation using the second training pattern in response to receiving the CA training command.

## Description

### BACKGROUND

### TECHNICAL FIELD

The present disclosure relates to storage devices and operating methods thereof.

### DESCRIPTION OF THE RELATED ART

Semiconductor memories can be classified into volatile memory devices that lose stored data when power is cut off, such as a static RAM (SRAM), a dynamic RAM (DRAM), and a synchronous DRAM (SDRAM), and nonvolatile memory devices that retain stored data even when power is cut off, such as a read only memory (ROM), a programmable ROM (PROM), an electrically programmable ROM (EPROM), an electrically erasable and programmable ROM (EEPROM), a flash memory device, a phase-change RAM (PRAM), a magnetic RAM (MRAM), a resistive RAM (RRAM), and a ferroelectric RAM (FRAM).

A memory device may be configured to communicate with a storage controller based on various electrical signals. When electrical signals become distorted due to a variety of factors that occur during the operation of a memory device, the memory device may become incapable of transmitting and receiving data normally.

The above-mentioned information is intended to improve understanding of the background of the present disclosure and may include information not contained in a related art.

### SUMMARY

The present disclosure relates to storage devices and operating methods thereof to solve and/or improve upon the above-mentioned problem.

The problems to be resolved by the present disclosure are not limited to that described above, and the following description of the present disclosure would allow a person having ordinary skill in the art to clearly understand other problems not mentioned above.

A storage device, according to some example embodiments of the present disclosure, includes a storage controller including a first data pin and a first command/address (CA) pin and a memory device including a second data pin connected to the first data pin through a data line and a second CA pin connected to the first CA pin through a CA line. The storage controller is configured to transmit a CA training command to the memory device through the data line to start a CA training operation and a first training pattern to the memory device through the CA line, and the memory device is configured to receive the CA training command through the data line, receive a second training pattern through the CA line when the storage controller transmits the first training pattern, and perform the CA training operation using the second training pattern in response to receiving the CA training command.

A storage device, according to some example embodiments of the present disclosure, includes a storage controller including a first data pin and a first command/address (CA) pin and a memory device including a second data pin connected to the first data pin through a data line and a second CA pin connected to the first CA pin through a CA line. The storage device is configured to operate in one of a plurality of CA operation modes, the plurality of CA operation modes including a first CA operation mode and a second CA operation mode, and a speed at which the memory device receives a plurality of CA signals through the CA line in the second CA operation mode is lower than a speed at which the memory device receives the plurality of CA signals through the CA line in the first CA operation mode. The storage controller is configured to transmit a CA training command to the memory device through the data line to start a CA training operation and a first training pattern to the memory device through the CA line while the storage device operates in the first CA operation mode. The memory device stores a target pattern, receives the CA training command through the data line, receives a second training pattern through the CA line when the storage controller transmits the first training pattern, performs the CA training operation using the second training pattern in response to receiving the CA training command, and transmits a training failure signal as a result signal indicating a result of performing the CA training operation to the storage controller through the data line in response to not determining that the target pattern and the second training pattern correspond to each other, and the storage controller is further configured to adjust at least one of a delay and a voltage of a CA signal transmitted through the CA line in response to receiving the training failure signal from the memory device.

According to some example embodiments of the present disclosure, an operating method of a storage device, including a storage controller including a first data pin and a first command/address (CA) pin and a memory device including a second data pin connected to the first data pin through a data line and a second CA pin connected to the first CA pin through a CA line, includes transmitting a CA training command to the memory device through the data line to start a CA training operation by the storage controller, transmitting a first training pattern to the memory device through the CA line by the storage controller, receiving the CA training command through the data line by the memory device, receiving a second training pattern through the CA line by the memory device when the storage controller transmits the first training pattern, and performing the CA training operation using the second training pattern by the memory device in response to receiving the CA training command.

According to some example embodiments of the present disclosure, an operating method of a memory device including receiving a command/address (CA) training command through a data pin, the CA training command instructing the memory device to being a CA training operation; receiving a training pattern through a CA pin; performing the CA training program using the training pattern in response to receiving the CA training command; transmitting a training result signal through the CA pin based on the memory device being in a first CA operation mode, or through the data pin based on the memory device being in a second CA operation mode.

According to some example embodiments of the present disclosure, the operating method may include a speed at which the memory device receives a plurality of data signals through the data line in the second data operation mode is lower than a speed at which the memory device receives the plurality of data signals through the data line in the first data operation mode.

According to some example embodiments of the present disclosure, it may be possible to prevent or reduce access to unexpected addresses of a memory device or damage to data through a command/address training operation.

According to some example embodiments of the present disclosure, the possibility that an operation of reading, writing, or erasing data will be carried out at an incorrect location may be reduced, thereby improving the reliability of a storage device.

According to some example embodiments of the present disclosure, it may be possible to perform a command/address training operation even when a command/address signal is transmitted at a high speed, thereby reducing the time and resources required for the command/address training operation and efficiently carrying out the command/address training operation.

At least some of the above and other features of the invention are set out in the claims. The effects of the present disclosure are not limited to those described above. The following description of the present disclosure would allow a person having ordinary skill in the art to clearly understand other technical effects thereof not mentioned above.

### BRIEF DESCRIPTION OF THE DRAWINGS

FIG. 1 is a block diagram for illustrating a storage system according to some embodiments of the present disclosure.
FIG. 2 is a block diagram for illustrating a storage device according to some embodiments of the present disclosure.
FIG. 3 is a block diagram for showing signals transmitted and received within a storage device.
FIG. 4 is a block diagram for illustrating a storage device according to some embodiments of the present disclosure.
FIG. 5 is a view for illustrating the internal structure of the memory device in FIG. 4 in more detail.
FIG. 6 shows the general operations of the storage device in FIG. 5.
FIG. 7 shows different operation modes of a command/address clock signal of the storage device in FIG. 5.
FIG. 8 shows an example of how a command/address signal is transmitted in a high-speed CA operation mode.
FIG. 9 is a flowchart for illustrating an example of a command/address training operation according to some example embodiments of the present disclosure.
FIG. 10 shows, in detail, the path of data transmitted and received while a command/address training operation is performed.
FIG. 11 shows, in detail, signals used for transmitting and receiving data during a command/address training operation.
FIG. 12 shows some example embodiments modified from some example embodiments as shown in FIG. 10.
FIG. 13 shows some example embodiments modified from some example embodiments as shown in FIG. 11.
FIG. 14 shows, in detail, the structure of the training circuit in FIGS. 10 and 12.
FIG. 15 shows specifically how a command/address training operation is performed using a training circuit.

### DETAILED DESCRIPTION

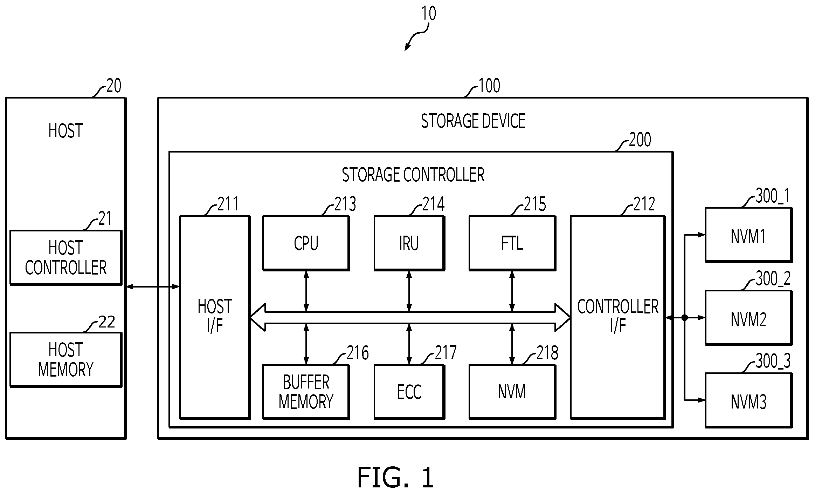

Hereinafter, some example embodiments of the present disclosure will be described with reference to FIGS. 1 to 15. The same reference numerals may refer to the same components throughout the present disclosure.

FIG. 1 is a block diagram for illustrating a storage system 10 according to some embodiments of the present disclosure. Referring to FIG. 1, the storage system 10 may include a host 20 and a storage device 100.

In some embodiments, the host 20 may include a host controller 21 and a host memory 22. The host memory 22 may serve as a buffer memory for temporarily storing data to be transmitted to the storage device 100 or data transmitted therefrom.

According to some example embodiments, the host controller 21 and the host memory 22 may be formed as separate semiconductor chips. In some example embodiments, the host controller 21 and the host memory 22 may be integrated as a single semiconductor chip. For example, the host controller 21 may be one of a plurality of modules provided in an application processor, and the application processor may be formed as a system on chip (SoC). In addition, the host memory 22 may be an embedded memory provided in the application processor, or a volatile memory or a memory module placed outside the application processor.

The host controller 21 may manage an operation of storing data, e.g., a record data (or writing data), of the host memory 22 in a nonvolatile memory device 300_1 to 300_3 or storing data, e.g., a reading data, of the memory device 300_1 to 300_3 in the host memory 22. For example, the host controller 21 may manage an operation of storing a user data related to the execution of a specific program in the nonvolatile memory device 300_1 to 300_3. For example, the host controller 21 may manage an operation of reading a user data from the nonvolatile memory device 300_1 to 300_3.

The storage device 100 may include a storage controller 200 and a plurality of nonvolatile memory devices 300_1 to 300_3. While some example embodiments show three nonvolatile memory devices 300_1 to 300_3, example embodiments are not limited thereto, and greater or fewer nonvolatile memory devices may be used.

The storage device 100 may include a storage medium for storing data by a request from the host 20. For example, the storage device 100 may include at least one of a solid state drive (SSD), an embedded memory, and a removable external memory. When the storage device 100 is an SSD, the storage device 100 may be a device that follows the non-volatile memory express (NVMe) standard. When the storage device 100 is an embedded memory or an external memory, the storage device 100 may be a device that follows the universal flash storage (UFS) or embedded multi-media card (eMMC) standard. The host 20 and the storage device 100 may each generate a packet according to an adopted standard protocol and transmit the packet.

When the nonvolatile memory device 300_1 to 300_3 includes a flash memory, the flash memory may include a 2D NAND memory array, or a 3D or vertical/bonding vertical NAND (VNAND) memory array. For another example, the storage device 100 may also include other various types of nonvolatile memory and/or volatile memory. For example, the storage device 100 may include at least one of volatile or nonvolatile memories, such as a static RAM (SRAM), a dynamic RAM (DRAM), a synchronous DRAM (SDRAM), a read only memory (ROM), a programmable ROM (PROM), an electrically programmable ROM (EPROM), an electrically erasable and programmable ROM (EEPROM), a magnetic RAM (MRAM), a spin-transfer torque MRAM, a conductive bridging RAM (CBRAM), a ferroelectric RAM (FeRAM), a phase RAM (PRAM), and a resistive RAM. At least some of the plurality of nonvolatile memory devices (NVMs) 300_1 to 300_3 may alternatively be volatile memory devices.

The storage controller 200 may include a host interface 211, a controller interface circuit 212, and a central processing unit (CPU) 213. In addition, the storage controller 200 may further include an index read unit (IRU) 214, a flash translation layer (FTL) 215, a buffer memory 216, an error correction code (ECC) engine 217, and an internal nonvolatile memory 218. The storage controller 200 may further include a working memory into which the flash translation layer (FTL) 215 is loaded, and operations of writing and reading data to the nonvolatile memory may be controlled as the CPU 213 executes the flash translation layer (FTL) 215. For example, as the CPU 213 executes the flash translation layer (FTL) 215, an operation of writing user data to the nonvolatile memory device 300_1 to 300_3 may be controlled.

The host interface 211 may exchange packets with the host 20. A packet transmitted from the host 20 to the host interface 211 may include a command, data, e.g., user data, to be written to the nonvolatile memory device 300_1 to 300_3, etc., and a packet transmitted from the host interface 211 to the host 20 may include a response to a command, data read from the nonvolatile memory device 300_1 to 300_3, etc. In the drawing, the host interface 211 is included in the storage controller 200, but the present disclosure is not limited thereto. For example, the host interface 211 may be placed outside the storage controller 200.

The controller interface circuit 212 may transmit data, e.g., user data, to be written to the nonvolatile memory device 300_1 to 300_3 to the nonvolatile memory device 300_1 to 300_3, or receive data, e.g., user data, read from the nonvolatile memory device 300_1 to 300_3. The controller interface circuit 212 may be configured to comply with a standard protocol such as toggle and the Open NAND Flash Interface (ONFI).

In some example embodiments, the index read unit (IRU) 214 may read data, for example, more efficiently or faster, corresponding to a mapping table or index from the nonvolatile memory device 300_1 to 300_3 and transfer the data to the CPU 213, a DMA engine, etc.

The flash translation layer 215 may perform various functions such as address mapping, wear-leveling, and/or garbage collection. In addition, the buffer memory 216 may temporarily store data to be written to a memory device 300 and/or data read from the nonvolatile memory device 300_1 to 300_3. The buffer memory 216 may be a component placed within the storage controller 200, but may also be positioned outside the storage controller 200.

The ECC engine 217 may serve to detect errors in read data read from the nonvolatile memory device 300_1 to 300_3 and correcting them. More specifically, the ECC engine 217 may generate a parity bit for write data to be written to the nonvolatile memory device 300_1 to 300_3, and the parity bit may be stored in the nonvolatile memory device 300_1 to 300_3 together with the write data. When reading data from the nonvolatile memory device 300_1 to 300_3, the ECC engine 217 may correct errors in read data using a parity bit read from the nonvolatile memory device 300_1 to 300_3 together with the read data and output the read data the errors of which have been corrected.

The internal nonvolatile memory 218 may store multiple sets of defense code parameters for each of the plurality of nonvolatile memory devices 300_1 to 300_3. A set of defense code parameters according to some embodiments may be any one of information sets, such as a read retry table, a wordline-by-wordline read retry table, a temperature-by-temperature read level offset table, a patrol read information, a variable erase/program operation voltage information per an endurance cycle, and a read refresh table.

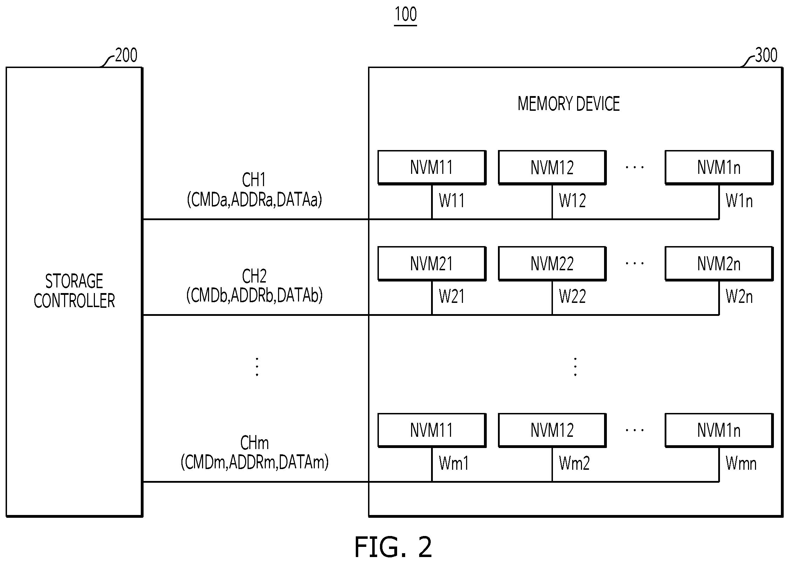

FIG. 2 is a block diagram for illustrating the storage device 100 according to some embodiments.

Referring to FIG. 2, the memory device 300 and the storage controller 200 may be connected to each other through a plurality of channels CH1 to CHm.

The memory device 300 may include a plurality of nonvolatile memory devices NVM11 to NVMmn. Here, "m" and "n" may be natural numbers. The plurality of nonvolatile memory devices NVM11 to NVMmn may correspond to the plurality of nonvolatile memory devices 300_1 to 300_3 in FIG. 1.

Each of the nonvolatile memory devices NVM11 to NVMmn may be connected to the storage controller 200 by being connected to one of the plurality of channels CH1 to CHm through a corresponding one of a plurality of ways W11 to Wmn. A "way" may be a communication path for allowing a corresponding channel to access a corresponding group of NVMs. In some example embodiments, each of the nonvolatile memory devices NVM11 to NVMmn may be formed as any memory unit that operates according to individual commands from the storage controller 200. For example, each of the nonvolatile memory devices NVM11 to NVMmn may be formed as a chip or a die, but the present disclosure is not limited thereto.

The storage controller 200 may exchange data signals with the memory device 300 through the plurality of channels CH1 to CHm. For example, the storage controller 200 may transmit a command CMDa to CMDm, an address ADDRa to ADDRm, and data DATAa to DATAm to the memory device 300 through the channel CH1 to CHm, or receive data DATAa to DATAm from the memory device 300.

The storage controller 200 may select one of the memory devices 300 connected to each channel through the channel and exchange signals with the nonvolatile memory device, which has been selected. In some example embodiments, each of the channels CH1 to CHm may include a command/address line and a plurality of data lines, which will be described below, and the plurality of nonvolatile memory devices may be selectively connected to one channel to communicate with the storage controller 200.

The storage controller 200 may exchange signals in parallel with the memory device 300 through different channels. For example, the storage controller 200 may transmit a command CMDa to a memory device NVM11 through a first channel CH1 while transmitting a command CMDb to a memory device NVM21 through a second channel CH2. For another example, the storage controller 200 may receive a data DATAa from the memory device NVM11 through the first channel CH1 while receiving a data DATAb from the memory device NVM21 through the second channel CH2.

FIG. 2 shows the memory device 300 communicating with the storage controller 200 through m channels and including n nonvolatile memory devices corresponding to their respective channels, but the number of the channels and the nonvolatile memory devices connected to one channel can be changed.

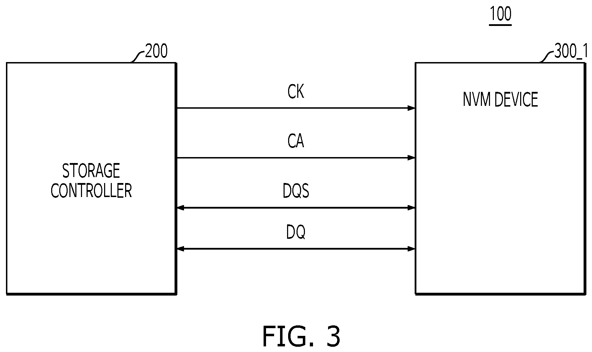

FIGS. 3 to 15 and some example embodiments of the present disclosure, which will be described below with reference to the drawings, will be illustrated or described based on the operation of the nonvolatile memory device 300_1, which is one of the plurality of nonvolatile memory devices NVM11 to NVMmn. However, this is only for convenience of description, and the present disclosure is not limited thereto.

FIG. 3 is a block diagram for showing signals transmitted and received within the storage device 100.

The storage controller 200 may transmit a clock signal CK and a command/address signal CA to the nonvolatile memory device 300_1, and may exchange a data signal DQ and a data strobe signal DQS with the nonvolatile memory device 300_1.

The nonvolatile memory device 300_1 may operate under the control of the storage controller 200. For example, the nonvolatile memory device 300_1 may receive the clock signal CK and the command/address signal CA from the storage controller 200. The command/address signal CA may be transmitted to the nonvolatile memory device 300_1 through a line separate from a line through which the data signal DQ is transmitted.

The nonvolatile memory device 300_1 may transmit data to the storage controller 200 or receive data therefrom in response to the command/address signal CA, which has been transmitted, through the data signal DQ and the data strobe signal DQS. The data signal DQ and the data strobe signal DQS may be transmitted and received through separate lines between the nonvolatile memory device 300_1 and the storage controller 200. The data signal DQ may be transmitted from the storage controller 200 to the nonvolatile memory device 300_1 or from the nonvolatile memory device 300_1 to the storage controller 200.

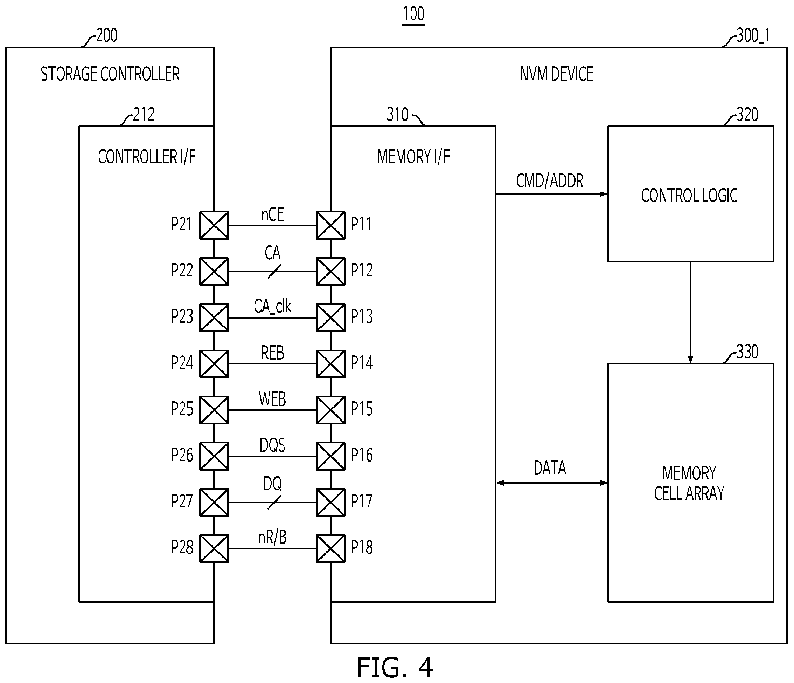

FIG. 4 is a block diagram for illustrating the storage device 100 according to some embodiments. The nonvolatile memory device 300_1 in FIG. 4 may correspond to any one of the nonvolatile memory devices NVM11 to NVMmn, where "m" and "n" are natural numbers, illustrated and described with reference to FIG. 2. Here, the storage controller 200 and the non-volatile memory device 300_1 can communicate with each other based on the separate command address (SCA) protocol.

The nonvolatile memory device 300_1 may include first to eighth pins P11 to P18, a memory interface circuit 310, a control logic circuit 320, and a memory cell array 330.

The storage controller 200 may include first to eighth pins P21 to P28 and the controller interface circuit 212. The first to eighth pins P21 to P28 of the storage controller 200 may correspond to the first to eighth pins P11 to P18 of the nonvolatile memory device 300_1.

The controller interface circuit 212 may transmit a chip enable signal nCE to the nonvolatile memory device 300_1 through the first pin P21, and the memory interface circuit 310 may receive the chip enable signal nCE from the storage controller 200 through the first pin P11. The controller interface circuit 212 may exchange signals with the nonvolatile memory device 300_1 selected from a plurality of connected memory devices through the chip enable signal nCE through the second to eighth pins P22 to P28, and the memory interface circuit 310 may exchange signals with the storage controller 200 through the second to eighth pins P12 to P18 according to the chip enable signal nCE. For example, when the chip enable signal nCE is in an enabled state, e.g., a low level, the memory interface circuit 310 may exchange signals with the storage controller 200 through the second to eighth pins P12 to P18.

The controller interface circuit 212 may transmit a command/address signal CA and a command/address clock signal CA_clk to the nonvolatile memory device 300_1 through the second and third pins P22 and P23, respectively, and the memory interface circuit 310 may receive them through the second and third pins P12 and P13, respectively. The command/address signal CA may be transmitted in place of the existing command latch enable signal, e.g., CLE, and address latch enable signal, e.g., ALE, in the separate command address (SCA) protocol. The command/address signal CA may be transmitted through multiple pins. For example, the second pin P22 of the controller interface circuit 212 may include a plurality of pins, e.g., two pins, and the second pin P12 of the memory interface circuit 310 may include a plurality of pins, e.g., two pins, connected to the second pin P22 of the controller interface circuit 212.

The memory interface circuit 310 may receive a command CMD and an address ADDR from the storage controller 200. For example, the controller interface circuit 212 may transmit a writing enable signal WEB to the memory interface circuit 310 through the fifth pin P25, and the memory interface circuit 310 may receive the writing enable signal WEB from the storage controller 200 through the fifth pin P15. The memory interface circuit 310 may obtain the command CMD and/or the address ADDR through the second pin P12 according to the command/address clock signal CA_clk based on the toggle timings of the writing enable signal WEB. In the present disclosure, the second pin P12 of the memory interface circuit 310 and the second pin P22 of the controller interface circuit 212 may be referred to as a "command/address pin" or a "CA pin." In addition, in the present disclosure, a line connecting the second pin P12 of the memory interface circuit 310 and the second pin P22 of the controller interface circuit 212, e.g.,, a line through which the command CMD and the address ADDR are transmitted to the memory interface circuit 310, may be referred to as a "command/address line" or a "CA line."

The controller interface circuit 212 may transmit a reading enable signal REB through the fourth pin P14, and the memory interface circuit 310 may receive the reading enable signal REB through the fourth pin P14. The memory interface circuit 310 may receive a data strobe signal DQS from the storage controller 200 or transmit the data strobe signal DQS to the storage controller 200 through the sixth pin P16 in response to receiving the reading enable signal REB.

The controller interface circuit 212 may transmit a data signal DQ to the nonvolatile memory device 300_1 or receive the data signal DQ from the nonvolatile memory device 300_1 through the seventh pin P27. The memory interface circuit 310 may receive the data signal DQ from the storage controller 200 or transmit the data signal DQ to the storage controller 200 through the seventh pin P17 based on the toggle timing of the data strobe signal DQS. That is, data DATA may be transmitted through the data signal DQ.

For example, the data signal DQ may be transmitted through a data line connecting the seventh pin P17 of the memory interface circuit 310 and the seventh pin P27 of the controller interface circuit 212. The seventh pin P17 may include a plurality of pins, e.g., eight data pins, corresponding to a plurality of data signals.

In the present disclosure, the seventh pin P17 of the memory interface circuit 310 and the seventh pin P27 of the controller interface circuit 212 may be referred to as a "data pin" or a "DQ pin."

The memory interface circuit 310 may transmit a ready/busy output signal nR/B to the storage controller 200 through the eighth pin P18, and the controller interface circuit 212 may receive the ready/busy output signal nR/B through the eighth pin P28. The memory interface circuit 310 may transmit information on the status of the nonvolatile memory device 300_1 to the storage controller 200 through the ready/busy output signal nR/B.

When the nonvolatile memory device 300_1 is in a busy state, that is, internal operations of the nonvolatile memory device 300_1 are being performed, the memory interface circuit 310 may transmit the ready/busy output signal nR/B indicating the busy state to the storage controller 200. For example, while the nonvolatile memory device 300_1 programs the data DATA into the memory cell array 330 in response to a program command or reads the data DATA from the memory cell array 330 in response to a page reading command, the memory interface circuit 310 may transmit the ready/busy output signal nR/B indicating the busy state to the storage controller 200.

When the nonvolatile memory device 300_1 is in a ready state, that is, the internal operations of the nonvolatile memory device 300_1 are not performed or have been completed, the memory interface circuit 310 may transmit the ready/busy output signal nR/B indicating the ready state to the storage controller 200.

The controller interface circuit 212 may determine information on the status of the nonvolatile memory device 300_1 based on the ready/busy output signal nR/B.

The control logic circuit 320 may control various operations of the nonvolatile memory device 300_1. The control logic circuit 320 may receive an obtained command/address CMD/ADDR from the memory interface circuit 310. The control logic circuit 320 may generate control signals for controlling other components of the nonvolatile memory device 300_1 according to the received command/address CMD/ADDR. For example, the control logic circuit 320 may generate various control signals for programming the data DATA into the memory cell array 330 or for reading the data DATA from the memory cell array 330. For another example, the control logic circuit 320 may also generate control signals for adjusting channel potential within the memory cell array.

The memory cell array 330 may store the data DATA obtained from the memory interface circuit 310 under the control of the control logic circuit 320. In the present disclosure, the memory cell array 330 may output the stored data DATA to the memory interface circuit 310 under the control of the control logic circuit 320. In addition, the memory cell array 330 may adjust the channel potential within the memory cell array 330 under the control of the control logic circuit 320.

The memory cell array 330 may include a plurality of memory cells. For example, the plurality of memory cells may comprise (e.g. may be) flash memory cells. However, the present disclosure is not limited thereto, and the memory cells may comprise (e.g. may be) one or more of resistive random access memory (RRAM) cells, ferroelectric random access memory (FRAM) cells, phase change random access memory (PRAM) cells, thyristor random access memory (TRAM) cells, and magnetic random access memory (MRAM) cells.

The controller interface circuit 212 and the memory interface circuit 310, which have been described with reference to FIG. 4, are examples, and the present disclosure is not limited thereto. For example, the controller interface circuit 212 and the memory interface circuit 310 may further include pins for transmitting and receiving signals other than the signals illustrated and described with reference to FIG. 4. In another example, some of the plurality of pins P11 to P18 and P21 to P28 of the controller interface circuit 212 and the memory interface circuit 310 may be removed from the controller interface circuit 212 and the memory interface circuit 310 or integrated with other pins. The number, arrangement and/or order of the pins described herein may be changed.

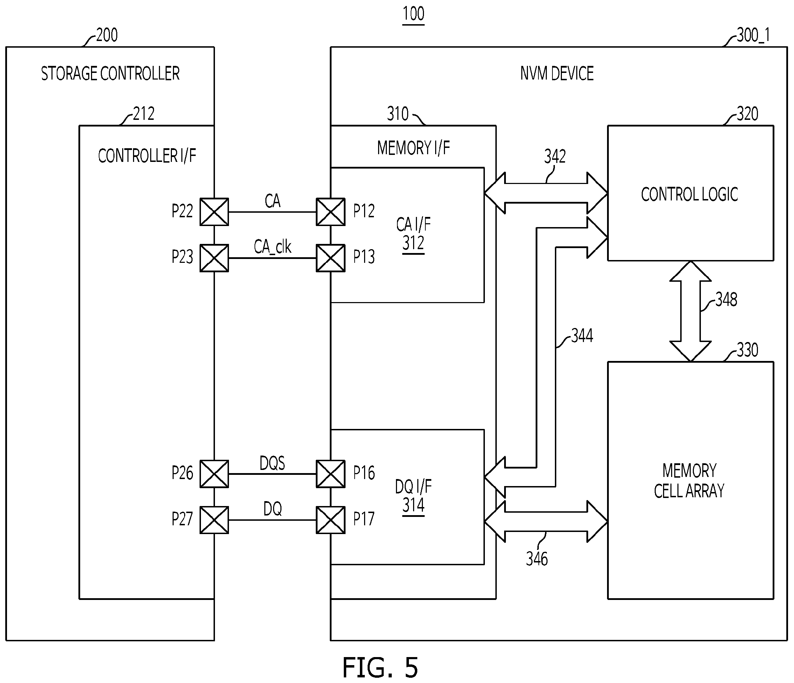

FIG. 5 is a view for illustrating the internal structure of the memory device 300_1 in FIG. 4 in more detail.

The memory interface circuit 310 may include a command/address interface circuit 312 and a data interface circuit 314.

The controller interface circuit 212 may transmit the command/address signal CA and the command/address clock signal CA_clk to the nonvolatile memory device 300_1 through the second and third pins P22 and P23, respectively, and the command/address interface circuit 312 may receive them through the second and third pins P12 and P13, respectively.

The controller interface circuit 212 may transmit the data strobe signal DQS to the nonvolatile memory device 300_1 or receive the data strobe signal DQS from the nonvolatile memory device 300_1 through sixth pin P26. The data interface circuit 314 may receive the data strobe signal DQS from the storage controller 200 or transmit the data strobe signal DQS to the storage controller 200 through the sixth pin P16.

The controller interface circuit 212 may transmit the data signal DQ to the nonvolatile memory device 300_1 or receive the data signal DQ from the nonvolatile memory device 300_1 through the seventh pin P27. The data interface circuit 314 may receive the data signal DQ from the storage controller 200 or transmit the data signal DQ to the storage controller 200 through the seventh pin P17 based on the toggle timing of the data strobe signal DQS.

The controller interface circuit 212 in FIG. 5 is a single circuit, but the present disclosure is not limited thereto. For example, the controller interface circuit 212 may include a first interface circuit connected to the command/address interface circuit 312 and a second interface circuit connected to the data interface circuit 314. Here, the first interface circuit may include the second pin P22 and the third pin P23, and the second interface circuit may include the sixth pin P26 and the seventh pin P27.

FIG. 5 may only show some of the pins shown in FIG. 4 and the signals transmitted and received through the pins. However, this is only for convenience of description, and the present disclosure is not limited thereto.

The command/address interface circuit 312 may be connected to the control logic circuit 320 through a first bus 342.

The data interface circuit 314 may be connected to the control logic circuit 320 through a second bus 344 and to the memory cell array 330 through a third bus 346.

The control logic circuit 320 and the memory cell array 330 may be connected to each other through a fourth bus 348.

Data or signals may be transmitted and received through the first to fourth buses 342, 344, 346, and 348.

The first to fourth buses 342, 344, 346, and 348 have been illustrated as separate components for convenience of description, but the present disclosure is not limited thereto. For example, at least some of the first to fourth buses 342, 344, 346, and 348 may be configured or referred to as one bus.

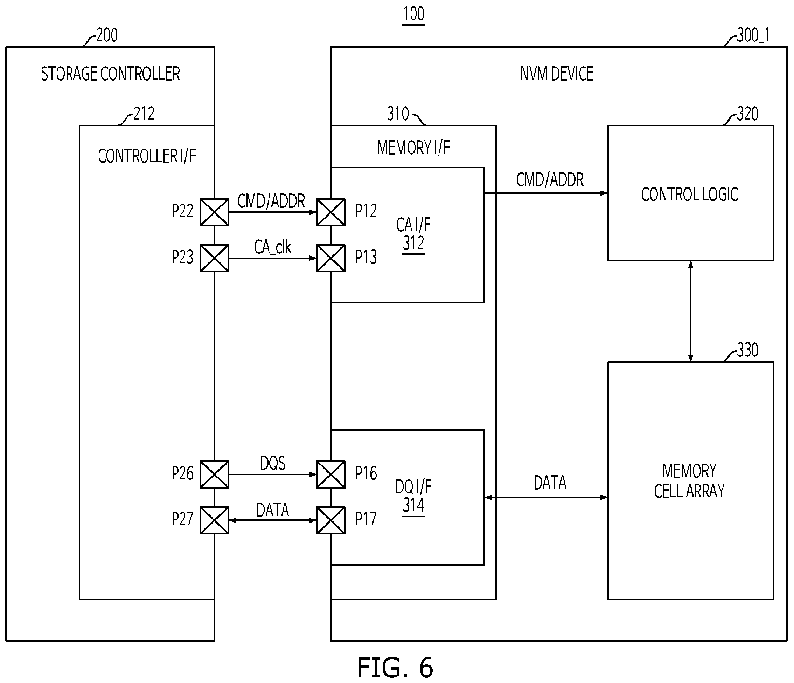

FIG. 6 shows the general operations of the storage device 100 in FIG. 5.

Referring to FIG. 6, the controller interface circuit 212 may transmit the command/address signal CA to the command/address interface circuit 312 through the second pin P22, thereby transmitting a specific command CMD and the address ADDR of the memory device 300_1 to be accessed to the command/address interface circuit 312. The command/address interface circuit 312 may receive the command CMD and the address ADDR through the second pin P12.

Referring to FIGS. 5 and 6, the command/address interface circuit 312 may transmit the command CMD and the address ADDR, which have been received, to the control logic circuit 320. For example, the command/address interface circuit 312 may transmit the command CMD and the address ADDR, which have been received, to the control logic circuit 320 through the first bus 342 in FIG. 5.

The controller interface circuit 212 may transmit the data DATA to the nonvolatile memory device 300_1 or receive the data DATA from the nonvolatile memory device 300_1 through the seventh pin P27. The data interface circuit 314 may transmit the data DATA to the controller interface circuit 212 or receive the data DATA from the storage controller 200 through the seventh pin P17.

Referring to FIGS. 5 and 6, the data interface circuit 314 may exchange the data DATA with the memory cell array 330. The data interface circuit 314 may transmit and receive the data DATA through the third bus 346 in FIG. 5.

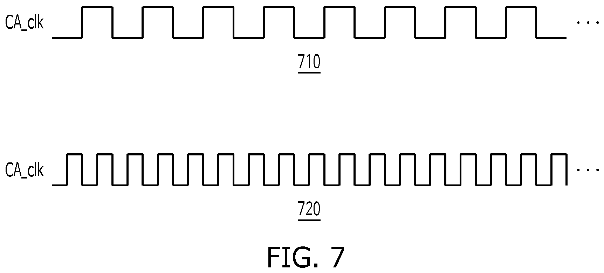

FIG. 7 shows different operation modes of the command/address clock signal CA_clk of the storage device 100 in FIG. 5.

Referring to FIGS. 5 and 7, the storage device 100 may be configured to operate in any one of a plurality of CA operation modes. The plurality of CA operation modes in which the storage device 100 operates may include a high-speed CA operation mode (e.g. a first CA operation mode) or a low-speed CA operation mode (e.g. a second CA operation mode). The speed (e.g. frequency or rate) at which the memory device 300_1 receives a plurality of CA signals (e.g. the speed (e.g. frequency or rate) at which the storage controller send the plurality of CA signals) through a CA line in the low-speed CA operation mode may be lower than the speed (e.g. frequency or rate) at which the memory device receives the plurality of CA signals (e.g. the speed (e.g. frequency or rate) at which the storage controller send the plurality of CA signals) through the CA line in the high-speed CA operation mode.

For example, the first example 710 is an example of the command/address clock signal CA_clk of the storage device 100 operating in the low-speed CA operation mode, and the second example 720 is an example of the command/address clock signal CA_clk of the storage device 100 operating in the high-speed CA operation mode.

Meanwhile, similarly, the storage device 100 may be configured to operate in any one of a plurality of data operation modes. For example, the plurality of data operation modes may include a high-speed data operation mode (e.g. a first data operation mode) or a low-speed data operation mode (e.g. a second data operation mode). The speed (e.g. frequency or rate) at which the memory device 300_1 receives a plurality of data signals through a data line in the low-speed data operation mode may be lower than the speed (e.g. frequency or rate) at which the memory device 300_1 receives the plurality of data signals through the data line in the high-speed data operation mode.

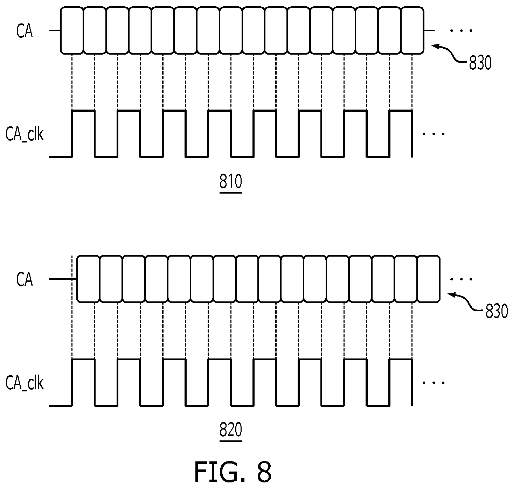

FIG. 8 shows an example of how the command/address signal is transmitted in the high-speed CA operation mode.

When a storage device, e.g., the storage device 100 in FIG. 5, operates normally in the high-speed CA operation mode, the command/address clock signal CA_clk may be generated regularly, and the command/address signal CA may be transmitted at an appropriate time point based on edges, e.g., rising and falling edges, of the command/address clock signal CA_clk. For example, as in the first example 810, a plurality of packets 830, which are transmitted through the command/address signal CA, may be aligned and transmitted based on the rising and falling edges of the command/address clock signal CA_clk.

As in the first example 810, the storage device may be designed so that the timing of the command/address clock signal CA_clk and the command/address signal CA are not misaligned, and the internal circuit of the storage device may sample the command/address signal CA to sufficiently satisfy a required setup time and a hold time. When such normal timing is secured, a memory device, e.g., 300_1 in FIG. 5, may accurately interpret commands and addresses and stably access pages or blocks of a memory cell array, e.g., 330 in FIG. 5 to normally perform reading, writing, or erasing operation, etc.

However, as in the second example 820, in an abnormal situation where the timing of the command/address clock signal CA_clk and the command/address signal CA are misaligned, the internal latch circuit of the memory device may misinterpret the commands and/or addresses, and the command/address signal CA may be captured at an unexpected time point at each edge of the command/address clock signal CA_clk, causing confusion of multiple bits. As a result, the memory device may access unintended addresses or attempt to execute unrecognized commands, which may result in stability problems, such as writing data to incorrect locations, erasing inappropriate blocks, etc.

In addition, when the voltage level of the command/address clock signal CA_clk becomes unstable, it may be difficult for the command/address signal CA to be properly recognized within the memory device. For example, when a voltage level that should be considered a logic "1" actually falls below a threshold or, conversely, a transient signal that could be recognized as a logic "0" occurs, the internal circuitry of the memory device may be more likely to incorrectly determine that a clock edge has not been input normally or that multiple clock pulses have occurred. This may cause the command/address signal CA to be sensed unstably even when the clock timing is accurate.

The misalignment of the command/address clock signal CA_clk and the command/address signal CA and/or an unstable voltage level of the command/address clock signal CA_clk, which have been described above, may be more likely to occur as the cycle of the command/address clock signal CA_clk becomes shorter.

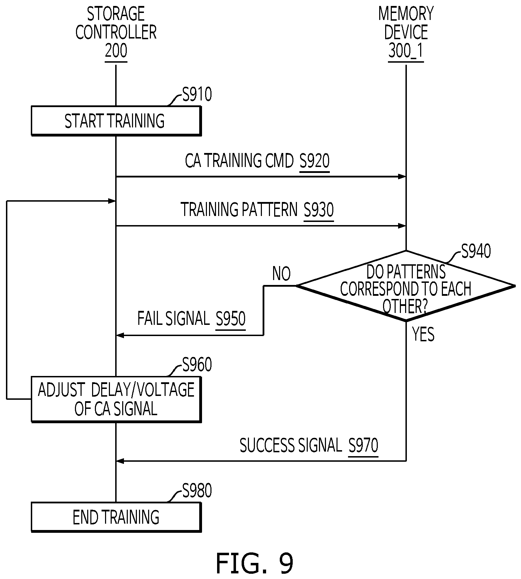

Therefore, an operation, e.g., a command/address training operation, of training the phase, timing, and/or voltage level of the command/address clock signal CA_clk and the command/address signal CA regularly or at the initial drive time may be required, and the command/address training operation may compensate for various timing deviations and/or voltage level deviations that may occur in real-world environments including temperature changes, power supply fluctuations, etc. As discussed below, some example embodiments of the command/address training operation will be described in detail with reference to FIGS. 9 to 15.

FIG. 9 is a flowchart for illustrating an example of a command/address training operation according to some example embodiments of the present disclosure.

The storage controller 200 may start a command/address training at S910.

The storage controller 200 may transmit a command/address training command to start the command/address training to the memory device 300_1 at S920.

In some example embodiments, the storage controller 200 may initiate the command/address training operation and transmit the command/address training command to the memory device 300_1 when a storage device, e.g., 100 in FIG. 5, is first started to operate (e.g. is connected, powered-up or booted).

In some example embodiments, when, although a specific command (e.g. a command), e.g., a reading command, a writing command, an erasing command, etc., has been transmitted to the memory device 300_1 through a command/address line to request the memory device 300_1 to perform a specific operation (e.g. an operation), the specific operation, e.g., a reading operation, a writing operation, an erasing operation, etc., fails, in response thereto, the storage controller 200 may initiate the command/address training operation and transmit the command/address training command to the memory device 300_1 through a data line.

The storage controller 200 may transmit a training pattern used for the command/address training operation to the memory device 300_1 at S930.

Although steps S910 to S930 are performed sequentially in the drawing, the present disclosure is not limited thereto. For example, at least some of S910 to S930 may be carried out simultaneously or substantially simultaneously.

The memory device 300_1 may receive the command/address training command and the training pattern in S920 and S930, and compare the pattern (e.g. the received training pattern) with a target pattern (e.g., a pre-stored target pattern, a desired target pattern, and/or a determined target pattern) to determine whether they correspond to each other at S940. The training pattern transmitted by the storage controller may match the target pattern. Accordingly, where the training pattern received by the memory device 300_1 differs from the target pattern, the memory device 300_1 may determine that adjustment of signal parameter(s) is required (e.g. that the delay and/or voltage of the command/address signal requires adjusting). Based on the result of the determination in step S940, the memory device 300_1 may transmit a result signal indicating the result of performing the command/address training operation to the storage controller 200.

For example, in response to determining that the patterns do not correspond to each other at S940, the memory device 300_1 may transmit a training failure signal as a result signal to the storage controller 200 at S950.

In response to receiving the training failure signal from the memory device 300_1 at S950, the storage controller 200 may adjust the delay and/or the voltage, e.g., a voltage level, of a command/address signal transmitted through the command/address line at S960. For example, the storage controller 200 may adjust the delay of the CA signal by controlling a programmable delay element, such as a delay-locked loop (DLL) or a phase-locked loop (PLL), which may be included in the controller interface circuit 212. In response to receiving a training failure signal, the storage controller 200 may incrementally increase or decrease a delay value applied to the CA signal by a predetermined step. The storage controller 200 may then transmit the first training pattern with the adjusted delay and await a new result signal from the memory device 300_1. This process may be repeated until a training success signal is received, or until a predefined range of available delay values has been tested.

In another example, the storage controller 200 may adjust the voltage of the CA signal by controlling a programmable voltage driver or a digital-to-analog converter (DAC) associated with the first CA pin. In response to a training failure signal, the storage controller 200 may adjust a drive strength or a voltage level of the CA signal. For example, the voltage level may be incrementally increased or decreased by a predetermined amount. This adjustment may serve to improve the signal integrity of the CA signal as received by the memory device 300_1, ensuring that logic levels are recognized correctly. The storage controller 200 may then re-transmit the first training pattern using the adjusted voltage level.

According to some example embodiments, the storage controller 200 may perform the adjustment of the delay and the voltage in a sequential or combined manner. For example, the storage controller 200 may first iterate through a full range of possible delay values for the CA signal while maintaining a constant voltage level. If the CA training operation still fails after testing all delay values, the storage controller 200 may then increment the voltage level of the CA signal to a next setting and once again perform the iteration through the range of delay values. This systematic search may be repeated for a plurality of voltage levels until the CA training operation is successfully completed.

The storage controller 200 and the memory device 300_1 may repeat S930 and S940 after the delay and/or the voltage, e.g., a voltage level, of the command/address signal has been adjusted. For example, the storage controller 200 may transmit a training pattern again to the memory device 300_1 at S930, and the memory device 300_1 may compare the received training pattern with the target pattern to determine whether they correspond to each other at S940.

In response to determining that the patterns correspond to each other at S940, the memory device 300_1 may transmit a training success signal as a result signal to the storage controller 200 at S970.

In response to receiving the training success signal from the memory device 300_1 at S970, the storage controller 200 may end the command/address training operation at S980.

After the command/address training operation has ended or been completed, the storage controller 200 may transmit a command, e.g., a reading command, a writing command, an erasing command, etc., and an address, e.g., an address corresponding to the command, to the memory device 300_1 through the command/address line.

As a result of performing the command/address training operation in FIG. 9, access to an unexpected address of the memory device or damage to data may be prevented or reduced. In addition, the possibility that an operation of reading, writing, or erasing data will be carried out at an incorrect location may be reduced, thereby improving the reliability of the storage device. For example, according to some example embodiments, there may be an improvement in use of memory devices and performance thereof based on the above methods. Therefore, the improved devices and methods overcome the deficiencies of the conventional devices and methods while reducing errors in operation and resource consumption, while improving memory fidelity, accuracy, and reliability, and device longevity.

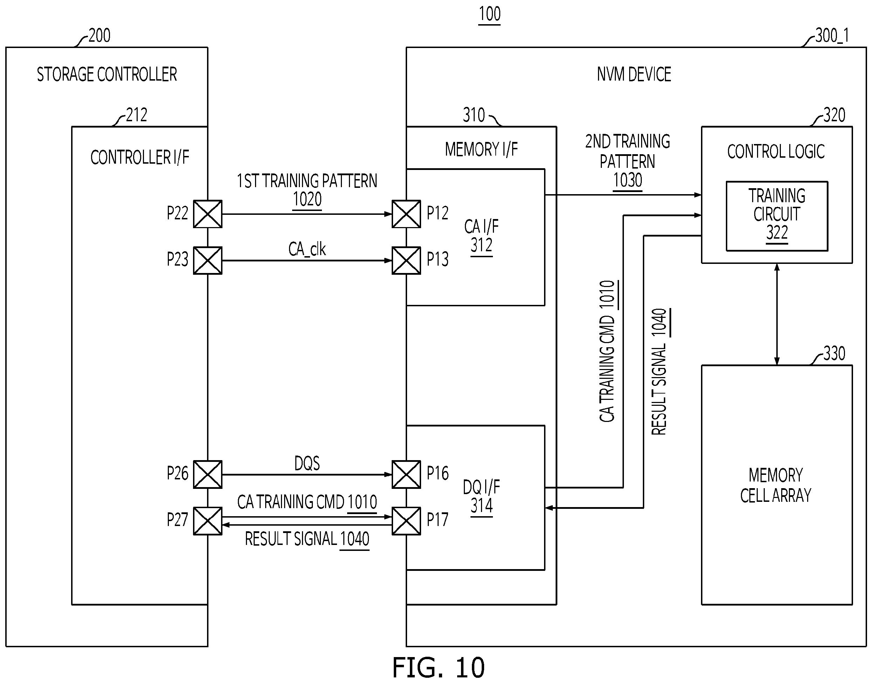

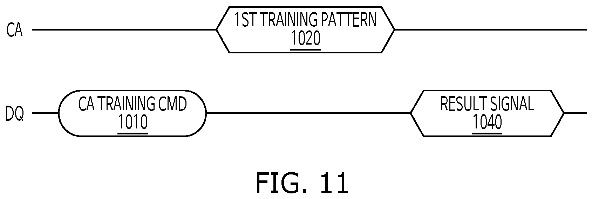

FIG. 10 shows, in detail, the path of data transmitted and received while a command/address training operation is performed, and FIG. 11 shows, in detail, signals used for transmitting and receiving the data during the command/address training operation.

Referring to FIGS. 9 and 10, the storage controller 200 (e.g. the controller interface circuit 212) may transmit a command/address training command 1010 in S920 in FIG. 9 to the memory device 300_1 (e.g. the data interface circuit 314) through a data line using the seventh pin P27. The memory device 300_1 (e.g. the data interface circuit 314) may receive the command/address training command 1010 through the data line and the seventh pin P17. Referring to FIG. 11, the command/address training command 1010 may be transmitted to the memory device 300_1 through the data line using the data signal DQ.

In some example embodiments, the storage controller 200 may transmit the command/address training command 1010 to the memory device 300_1 through the data line to start the command/address training operation while the storage device 100 is operating in the low-speed data operation mode. In some example embodiments, after the storage device 100 has fully performed an operation of training data received through a data line, the storage controller 200 may transmit the command/address training command 1010 to the memory device 300_1 through the data line. Here, the fact that the operation of training the data has been fully performed may mean that the operation has been successfully completed. In this case, the storage controller 200 may transmit the command/address training command 1010 to the memory device 300_1 through the data line in any data operation mode, including the high-speed data operation mode and the low-speed data operation mode.

As a result, it may be possible for the command/address training command 1010 to be transmitted to the memory device 300_1 without data distortion. For example, even when the command/address clock signal CA_clk operates abnormally, the command/address training command 1010 may be transmitted to the memory device 300_1.

The command/address training command 1010 received by the data interface circuit 314 may be transmitted to the control logic circuit 320. For example, the command/address training command 1010 may be transmitted to the control logic circuit 320 through the second bus 344 in FIG. 5.

Referring to FIGS. 9 and 10, the storage controller 200 (e.g. the controller interface circuit 212) may transmit a first training pattern 1020 corresponding to the training pattern transmitted in S930 in FIG. 9 to the memory device 300_1 (e.g. the command/address interface circuit 312) through a command/address line using the second pin P22. Referring to FIG. 11, the first training pattern 1020 may be transmitted to the memory device 300_1 through the command/address line using the command/address signal CA.

The command/address training operation may be performed while the storage device is operating in the high-speed CA operation mode. In some example embodiments, the first training pattern 1020 may be transmitted to the memory device 300_1 through the command/address line while the storage device is operating in the high-speed CA operation mode.

When the storage controller 200 transmits the first training pattern 1020, the memory device 300_1 (e.g. the command/address interface circuit 312) may receive a second training pattern 1030 through a command/address line and the second pin P12. The first training pattern 1020 transmitted by the storage controller 200 may match the target pattern. The second training pattern 1030 may be different from or the same as the first training pattern 1020 (e.g. different or the same as the target pattern) depending on the state of the command/address clock signal CA_clk, e.g., an abnormal or normal operation.

The received second training pattern 1030 may be transmitted to the control logic circuit 320. For example, the second training pattern 1030 may be transmitted to the control logic circuit 320 through the first bus 342 in FIG. 5.

For example, when the command/address clock signal CA_clk operates normally, the first training pattern 1020 and the second training pattern 1030 may match each other (e.g. the second training pattern 1030 may match the target pattern). In contrast, when the command/address clock signal CA_clk operates abnormally, resulting in an abnormal voltage level, an abnormal operation due to misalignment, etc., the first training pattern 1020 and the second training pattern 1030 may not match each other (e.g. the second training pattern 1030 may not match the target pattern).

The memory device 300_1 (e.g. the control logic circuit 320) may perform the command/address training operation using the second training pattern 1030 in response to receiving the command/address training command 1010.

The memory device 300_1 (e.g. the control logic circuit 320) may generate a result signal 1040 indicating the result of performing the command/address training operation based on the received second training pattern 1030 and a target pattern stored in the memory device 300_1. The target pattern (which may be pre-stored) in the memory device 300_1 may be a pattern to be compared with the second training pattern 1030 and for determining whether the command/address clock signal CA_clk is operating normally.

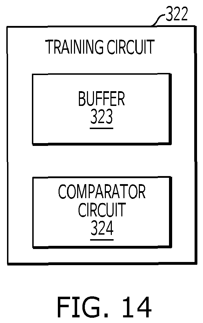

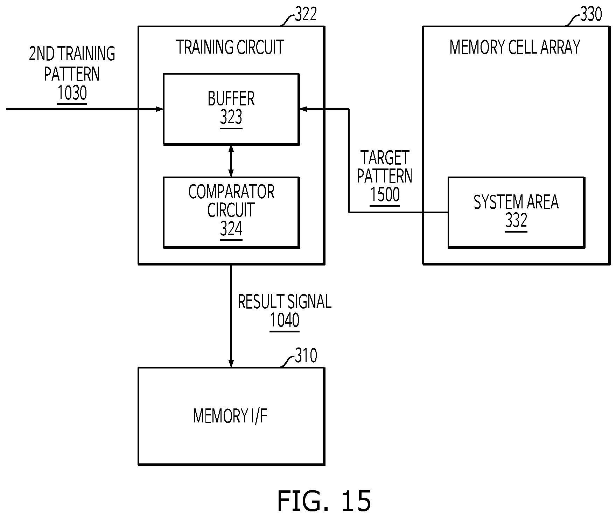

Referring to FIG. 10, the control logic circuit 320 may include a training circuit 322. The training circuit 322 may generate the result signal 1040 in response to receiving the command/address training command 1010. The specific structure and operation of the training circuit 322 will be described in detail below with reference to FIGS. 14 and 15.

The control logic circuit 320 may transmit the generated result signal 1040 to the data interface circuit 314. For example, the control logic circuit 320 may transmit the generated result signal 1040 to the data interface circuit 314 through the second bus 344 in FIG. 5.

The memory device 300_1 or the data interface circuit 314 may transmit the generated result signal 1040 to the storage controller 200. Referring to FIG. 11, the result signal 1040 may be transmitted to the storage controller 200 through a data line using the data signal DQ.

In some example embodiments, when the first training pattern 1020 and the second training pattern 1030 match each other, the target pattern and the second training pattern 1030 may correspond to each other. That is, when the memory device 300_1 determines that the second training pattern 1030 matches the target pattern, the memory device 300_1 may determine that the second training pattern 1030 matches the first training pattern 1020. In response to determining that the target pattern and the second training pattern 1030 correspond to each other, the memory device 300_1 may transmit a training success signal, e.g., the training success signal in S970 in FIG. 9, as the result signal 1040 to the storage controller 200.

In some example embodiments, when the first training pattern 1020 and the second training pattern 1030 do not match each other, the target pattern and the second training pattern 1030 may not correspond to each other. That is, when the memory device 300_1 determines that the second training pattern 1030 does not match the target pattern, the memory device 300_1 may determine that the second training pattern 1030 does not match the first training pattern 1020. In response to not determining that the target pattern and the second training pattern 1030 correspond to each other (e.g. in response to determining that the target pattern and the second training pattern 1030 do not correspond to (e.g. match) each other), the memory device 300_1 may transmit a training failure signal, e.g., the training failure signal in S950 in FIG. 9, as the result signal 1040 to the storage controller 200.

The storage controller 200 may adjust at least one of the delay and the voltage, e.g., a voltage level, of a command/address signal transmitted through a command/address line in response to receiving the training failure signal from the memory device 300_1. After adjustment, signal(s) (e.g. training pattern(s), command/address signal(s), etc.) transmitted through the command/address line may be transmitted using the adjusted delay and/or voltage.

The storage controller 200 may transmit the first training pattern 1020 back to the memory device 300_1 through a command/address line after adjusting at least one of the delay and the voltage of the command/address signal. On the other hand, the storage controller 200 may also transmit a pattern different from the first training pattern 1020 to the memory device 300_1.

When the storage controller 200 transmits the first training pattern 1020 or a pattern different therefrom after adjusting at least one of the delay and the voltage of the command/address signal, the memory device 300_1 may receive a third training pattern through a command/address line, and may transmit a training success signal as the result signal 1040 to the storage controller 200 in response to determining that the target pattern and the third training pattern correspond to each other.

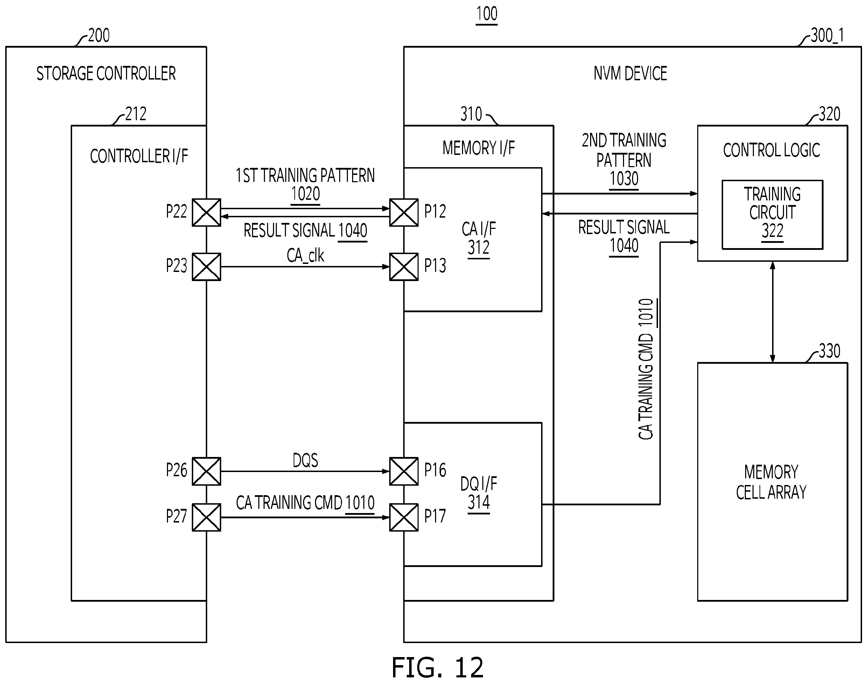

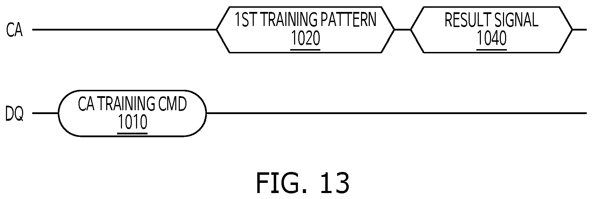

FIG. 12 shows some example embodiments modified from some example embodiments as shown in FIG. 10, and FIG. 13 shows some example embodiments modified from some example embodiments as shown in FIG. 11.

Referring to FIG. 12, the control logic circuit 320 may transmit the generated result signal 1040 to the command/address interface circuit 312. For example, the control logic circuit 320 may transmit the generated result signal 1040 to the command/address interface circuit 312 through the first bus 342 in FIG. 5.

The memory device 300_1 or the command/address interface circuit 312 may transmit the generated result signal 1040 to the storage controller 200 through the first pin P12.

Referring to FIG. 13, the result signal 1040 may be transmitted to the storage controller 200 through a command/address line using the command/address signal CA.

FIG. 14 shows in detail the structure of the training circuit 322 in FIGS. 10 and 12, and FIG. 15 shows specifically how a command/address training operation is performed using the training circuit 322.

Referring to FIG. 14, the training circuit 322 may include a buffer 323 that stores a pattern and a comparator circuit 324 that compares a plurality of patterns stored in the buffer 323 with each other to generate a result signal. In some example embodiments of the present disclosure, the buffer 323 and the comparator circuit 324 included in the control logic circuit 320 are illustrated and described with reference to FIGS. 12 and 14 together, but the present disclosure is not limited thereto. For example, the buffer 323 and/or the comparator circuit 324 may be placed outside the control logic circuit 320, e.g., at any location other than the memory cell array 330.

Referring to FIGS. 10, 12, and 15, the buffer 323 may store the second training pattern 1030 and a target pattern 1500. The present disclosure is not limited thereto, the buffer 323 may store a training pattern received in S930 for each cycle of S930 to S960 in FIG. 9. For example, a training pattern received in S930 of a previous cycle may be overwritten by a training pattern received in S930 of the current cycle.

The buffer 323 may receive the target pattern 1500 from the memory cell array 330. For example, a control logic circuit such as 320 in FIG. 5 of a memory device such as 300_1 in FIG. 5 may store the target pattern 1500 stored in the memory cell array 330 in the buffer 323.

The target pattern 1500 may be stored in a system area 332 of the memory cell array 330. The system area 332 of the memory cell array 330 may be a special area used by an internal controller, a firmware, and/or a device management logic to stably drive and manage a memory device, separate from a general user data storage space where a user directly accesses or stores data. Here, the system area 332 may be used to store metadata, etc., and may store block status information, e.g., information for indicating a good or bad block, data related to an error correction code (ECC), status information for performing internal algorithms such as wear-leveling, garbage collection, and bad block management, etc., for example. The system area 332 may store the above-mentioned data including the target pattern 1500 by using some of the plurality of memory cells of the memory cell array 330.

The comparator circuit 324 may compare the second training pattern 1030 stored in the buffer 323 and the target pattern 1500 to generate the result signal 1040. For example, the comparator circuit 324 may generate a training success signal as the result signal 1040 in response to determining that the target pattern 1500 and the second training pattern 1030 correspond to each other. For another example, the comparator circuit 324 may generate a training failure signal as the result signal 1040 in response to not determining that the target pattern 1500 and the second training pattern 1030 correspond to each other.

In some example embodiments, the comparator circuit 324 may determine that the target pattern 1500 and the second training pattern 1030 correspond to each other in response to the fact that some or all of the target pattern 1500 and the second training pattern 1030 match each other.

The training circuit 322 may transmit the result signal 1040 generated by the comparator circuit 324 to the memory interface circuit 310.

Any or all of the elements described with reference to the figures may communicate with any or all other elements described with reference to figures. For example, any element may engage in one-way and/or two-way and/or broadcast communication with any or all other elements in the figures, to transfer and/or exchange and/or receive information such as but not limited to data and/or commands, in a manner such as in a serial and/or parallel manner, via a bus such as a wireless and/or a wired bus (not illustrated). The information may be in encoded various formats, such as in an analog format and/or in a digital format.

As described herein, any electronic devices and/or portions thereof according to any of the example embodiments may include, may be included in, and/or may be implemented by one or more instances of processing circuitry such as hardware including logic circuits; a hardware/software combination such as a processor executing software; or any combination thereof. For example, the processing circuitry more specifically may include, but is not limited to, a central processing unit (CPU), an arithmetic logic unit (ALU), a graphics processing unit (GPU), an application processor (AP), a digital signal processor (DSP), a microcomputer, a field programmable gate array (FPGA), and programmable logic unit, a microprocessor, application-specific integrated circuit (ASIC), a neural network processing unit (NPU), an Electronic Control Unit (ECU), an Image Signal Processor (ISP), and the like. In some example embodiments, the processing circuitry may include a non-transitory computer readable storage device (e.g., a memory), for example a DRAM device, storing a program of instructions, and a processor (e.g., CPU) configured to execute the program of instructions to implement the functionality and/or methods performed by some or all of any devices, systems, modules, units, controllers, circuits, architectures, and/or portions thereof according to any of the example embodiments, and/or any portions thereof.

Embodiments are set out in the following Clauses:
Clause 1. A storage device comprising:
   a storage controller comprising a first data pin and a first command/address (CA) pin; and
   a memory device comprising a second data pin connected to the first data pin through a data line and a second CA pin connected to the first CA pin through a CA line,
   the storage controller configured to:
      transmit a CA training command to the memory device through the data line to start a CA training operation; and
      transmit a first training pattern to the memory device through the CA line, and the memory device configured to:
         receive the CA training command through the data line;
         receive a second training pattern through the CA line in response to the storage controller transmitting the first training pattern; and
         perform the CA training operation using the second training pattern in response to receiving the CA training command.
Clause 2. The storage device as claimed in Clause 1, wherein the memory device is further configured to:
   store a target pattern; and
   transmit, to the storage controller, a result signal indicating a result of performing the CA training operation based on the second training pattern and the target pattern.
Clause 3. The storage device as claimed in Clause 2, wherein the memory device is further configured to transmit a training success signal as the result signal to the storage controller in response to determining that the target pattern and the second training pattern correspond to each other.
Clause 4. The storage device as claimed in Clause 3, wherein, based on the first training pattern and the second training pattern matching each other, the target pattern and the second training pattern correspond to each other.
Clause 5. The storage device as claimed in any of Clauses 2-4, wherein the memory device is further configured to transmit a training failure signal as the result signal to the storage controller in response to not determining that the target pattern and the second training pattern correspond to each other.
Clause 6. The storage device as claimed in claim 5, wherein, based on the first training pattern and the second training pattern not matching each other, the target pattern and the second training pattern do not correspond to each other.
Clause 7. The storage device as claimed in Clause 5 or Clause 6, wherein the storage controller is further configured to adjust at least one of a delay or a voltage of a CA signal transmitted through the CA line in response to receiving the training failure signal from the memory device.
Clause 8. The storage device as claimed in Clause 7, wherein
   the storage controller is further configured to transmit the first training pattern to the memory device through the CA line, after adjusting at least one of the delay or the voltage of the CA signal, and
   the memory device is further configured to:
      receive a third training pattern through the CA line in response to the storage controller transmitting the first training pattern after adjusting at least one of the delay or the voltage of the CA signal; and
      transmit a training success signal as the result signal to the storage controller in response to determining that the target pattern and the third training pattern correspond to each other.
Clause 9. The storage device as claimed in any of Clauses 2-8, wherein the memory device is further configured to transmit the result signal to the storage controller through the data line.
Clause 10. The storage device as claimed in any of Clauses 2-8, wherein the memory device is further configured to transmit the result signal to the storage controller through the CA line.
Clause 11. The storage device as claimed in any of Clauses 2-10, wherein the memory device further comprises:
   a buffer configured to store the received second training pattern and the target pattern; and
   a comparator circuit configured to generate the result signal by comparing the second training pattern and the target pattern.
Clause 12. The storage device as claimed in Clause 11, wherein the memory device further comprises a memory cell array comprising a plurality of memory cells and a system area configured to store the target pattern by using a part of the plurality of memory cells, store the target pattern stored in the system area of the memory cell array in the buffer.
Clause 13. The storage device as claimed in any preceding Clause, wherein the storage controller is further configured to:
   transmit a specific command to the memory device through the CA line to request the memory device to perform a specific operation; and
   transmit the CA training command to the memory device through the data line in response to a failure of the specific operation.
Clause 14. The storage device as claimed in any preceding Clause, wherein
   the storage device is configured to operate in one of a plurality of CA operation modes, the plurality of CA operation modes comprising a first CA operation mode and a second CA operation mode,
   a speed at which the memory device receives a plurality of CA signals through the CA line in the second CA operation mode is lower than a speed at which the memory device receives the plurality of CA signals through the CA line in the first CA operation mode, and
   the storage controller is further configured to transmit the first training pattern to the memory device through the CA line while the storage device operates in the first CA operation mode.
Clause 15. The storage device as claimed in any preceding Clause, wherein
   the storage device is configured to operate in one of a plurality of data operation modes, the plurality of data operation modes comprising a first data operation mode and a second data operation mode,
   a speed at which the memory device receives a plurality of data signals through the data line in the second data operation mode is lower than a speed at which the memory device receives the plurality of data signals through the data line in the first data operation mode, and
   the storage controller is further configured to transmit the CA training command to the memory device through the data line while the storage device operates in the second data operation mode.
Clause 16. The storage device as claimed in any preceding Clause, wherein
   the storage device is configured to perform an operation of training data received through the data line, and
   the storage controller is further configured to transmit the CA training command to the memory device through the data line after the operation of training the data has been completed.
Clause 17. The storage device as claimed in any preceding Clause, wherein the storage controller is further configured to transmit a command and an address corresponding to the command to the memory device through the CA line after the CA training operation has been completed.
Clause 18. A storage device comprising:
   a storage controller comprising a first data pin and a first command/address (CA) pin; and
   a memory device comprising a second data pin connected to the first data pin through a data line and a second CA pin connected to the first CA pin through a CA line,
   the storage device configured to operate in one of a plurality of CA operation modes, the plurality of CA operation modes comprising a first CA operation mode and a second CA operation mode,
   a speed at which the memory device receives a plurality of CA signals through the CA line in the second CA operation mode is lower than a speed at which the memory device receives the plurality of CA signals through the CA line in the first CA operation mode,
   the storage controller configured to:
      transmit a CA training command to the memory device through the data line to start a CA training operation; and
      transmit a first training pattern to the memory device through the CA line while the storage device operates in the first CA operation mode,
   the memory device configured to:
      store a target pattern;
      receive the CA training command through the data line;
      receive a second training pattern through the CA line in response to the storage controller transmitting the first training pattern;
      perform the CA training operation using the second training pattern in response to receiving the CA training command; and
      transmit, to the storage controller, a training failure signal as a result signal indicating a result of performing the CA training operation through the data line in response to not determining that the target pattern and the second training pattern correspond to each other, and
   the storage controller is further configured to adjust at least one of a delay or a voltage of a CA signal transmitted through the CA line in response to receiving the training failure signal from the memory device.
Clause 19. An operating method of a storage device comprising a storage controller comprising a first data pin and a first command/address (CA) pin and a memory device comprising a second data pin connected to the first data pin through a data line and a second CA pin connected to the first CA pin through a CA line, the method comprising:
   transmitting, by the storage controller, a CA training command to the memory device through the data line to start a CA training operation;
   transmitting, by the storage controller, a first training pattern to the memory device through the CA line;
   receiving, by the memory device, the CA training command through the data line;
   receiving, by the memory device, a second training pattern through the CA line in response to the storage controller transmitting the first training pattern; and
   performing, by the memory device, the CA training operation using the second training pattern in response to receiving the CA training command.
Clause 20. The method as claimed in Clause 19, further comprising:
   transmitting, by the memory device, a training success signal to the storage controller in response to determining that a target pattern stored in the memory device and the second training pattern correspond to each other; and
   transmitting, by the memory device, a training failure signal to the storage controller in response to not determining that the target pattern and the second training pattern correspond to each other.

The present disclosure is not limited to the above-described example embodiments and the attached drawings. Various substitutions, modifications, and changes can be made to the present disclosure by a person having ordinary skill in the art within the scope of the technologies of the present disclosure, and should be deemed to fall within the scope of the present disclosure. For example, one or more steps of a process described with reference to each of the flowcharts in some drawings may be skipped, the order of the steps of the process may be changed, one or more steps may be performed simultaneously, and/or one or more steps may be repeated multiple times.

## Claims

1. A storage device comprising:
a storage controller (200) comprising a first data pin and a first command/address, CA, pin; and
a memory device (300_1) comprising a second data pin connected to the first data pin through a data line and a second CA pin connected to the first CA pin through a CA line,
the storage controller (200) being configured to:
transmit a CA training command (S920) to the memory device (300_1) through the data line to start a CA training operation; and
transmit a first training pattern (S930) to the memory device (300_1) through the CA line, and
the memory device (300_1) being configured to:
receive the CA training command through the data line;
receive a second training pattern through the CA line in response to the storage controller (200) transmitting the first training pattern; and
perform the CA training operation using the second training pattern in response to receiving the CA training command.

2. The storage device as claimed in claim 1, wherein the memory device (300_1) is further configured to:
store a target pattern; and
transmit, to the storage controller (200), a result signal indicating a result of performing the CA training operation based on the second training pattern and the target pattern.

3. The storage device as claimed in claim 2, wherein the memory device (300_1) is further configured to transmit a training success signal (S970) as the result signal to the storage controller (200) in response to determining that the target pattern and the second training pattern correspond to each other.

4. The storage device as claimed in claim 3, wherein, when the first training pattern and the second training pattern match each other, the target pattern and the second training pattern correspond to each other.

5. The storage device as claimed in any of claims 2-4, wherein the memory device (300_1) is further configured to transmit a training failure signal (S950) as the result signal to the storage controller (3200) in response to not determining that the target pattern and the second training pattern correspond to each other.

6. The storage device as claimed in claim 5, wherein, when the first training pattern and the second training pattern do not match each other, the target pattern and the second training pattern do not correspond to each other.

7. The storage device as claimed in claim 5 or claim 6, wherein
the storage controller (200) is further configured to:
adjust at least one of a delay or a voltage of a CA signal transmitted through the CA line in response to receiving the training failure signal from the memory device; and
transmit the first training pattern to the memory device (300_1) through the CA line, after adjusting at least one of the delay or the voltage of the CA signal, and
the memory device (300_1) is further configured to:
receive a third training pattern through the CA line in response to the storage controller (200) transmitting the first training pattern after adjusting at least one of the delay or the voltage of the CA signal; and
transmit a training success signal as the result signal to the storage controller in response to determining that the target pattern and the third training pattern correspond to each other.

8. The storage device as claimed in any of claims 2-7, wherein the memory device is further configured to transmit the result signal to the storage controller through the data line or the CA line.

9. The storage device as claimed in any of claims 2-8, wherein the memory device (300_1) further comprises:
a buffer (323) configured to store the received second training pattern and the target pattern;
a comparator circuit (324) configured to generate the result signal by comparing the second training pattern and the target pattern; and
a memory cell array comprising a plurality of memory cells and a system area configured to store the target pattern by using a part of the plurality of memory cells, and
wherein the memory device (300_1) is further configured to store the target pattern stored in the system area of the memory cell array in the buffer (323).

10. The storage device as claimed in any preceding claim, wherein the storage controller (200) is further configured to:
transmit a specific command to the memory device (300_1) through the CA line to request the memory device (300_1) to perform a specific operation; and
transmit the CA training command (S920) to the memory device (300_1) through the data line in response to a failure of the specific operation.

11. The storage device as claimed in any preceding claim, wherein
the storage device is configured to operate in one of a plurality of CA operation modes, the plurality of CA operation modes comprising a first CA operation mode and a second CA operation mode,
a speed at which the memory device (300_1) receives a plurality of CA signals through the CA line in the second CA operation mode is lower than a speed at which the memory device (300_1) receives the plurality of CA signals through the CA line in the first CA operation mode, and
the storage controller (200) is further configured to transmit the first training pattern to the memory device (300_1) through the CA line while the storage device operates in the first CA operation mode.

12. The storage device as claimed in any preceding claim, wherein
the storage device is configured to operate in one of a plurality of data operation modes, the plurality of data operation modes comprising a first data operation mode and a second data operation mode,
a speed at which the memory device (300_1) receives a plurality of data signals through the data line in the second data operation mode is lower than a speed at which the memory device (300_1) receives the plurality of data signals through the data line in the first data operation mode, and
the storage controller (200) is further configured to transmit the CA training command to the memory device (300_1) through the data line while the storage device operates in the second data operation mode.

13. The storage device as claimed in any preceding claim, wherein
the storage device is configured to perform an operation of training data received through the data line, and
the storage controller (200) is further configured to transmit the CA training command to the memory device (300_1) through the data line after the operation of training the data has been completed.

14. The storage device as claimed in any preceding claim, wherein the storage controller (200) is further configured to transmit a command and an address corresponding to the command to the memory device (300_1) through the CAline after the CAtraining operation has been completed.

15. An operating method of a storage device comprising a storage controller (200) comprising a first data pin and a first command/address, CA, pin and a memory device (300_1) comprising a second data pin connected to the first data pin through a data line and a second CA pin connected to the first CA pin through a CA line, the method comprising:
transmitting, by the storage controller (200), a CA training command (S920) to the memory device (300_1) through the data line to start a CA training operation;
transmitting, by the storage controller (200), a first training pattern (S930) to the memory device through the CA line;
receiving, by the memory device (300_1), the CA training command through the data line;
receiving, by the memory device (300_1), a second training pattern through the CA line in response to the storage controller (200) transmitting the first training pattern; and
performing, by the memory device (300_1), the CA training operation using the second training pattern in response to receiving the CA training command.

## Amended claims

### Amended claims in accordance with Rule 137(2) EPC.

1. A storage device comprising:
a storage controller (200) comprising a first data pin and a first command/address, CA, pin; and
a memory device (300_1) comprising a second data pin connected to the first data pin through a data line and a second CA pin connected to the first CA pin through a CA line,
the storage controller (200) being configured to:
transmit a CA training command (S920) to the memory device (300_1) through the data line to start a CA training operation; and
transmit a first training pattern (S930) to the memory device (300_1) through the CA line, and
the memory device (300_1) being configured to:
receive the CA training command through the data line;
receive a second training pattern through the CA line in response to the storage controller (200) transmitting the first training pattern;
perform the CA training operation using the second training pattern in response to receiving the CA training command; store a target pattern;
transmit, to the storage controller (200), a result signal indicating a result of performing the CA training operation based on the second training pattern and the target pattern; transmit a training success signal (S970) as the result signal to the storage controller (200) in response to determining that the target pattern and the second training pattern correspond to each other, wherein, when the first training pattern and the second training pattern match each other, the target pattern and the second training pattern correspond to each other.

2. The storage device as claimed in claim 1, wherein the memory device (300_1) is further configured to transmit a training failure signal (S950) as the result signal to the storage controller (3200) in response to not determining that the target pattern and the second training pattern correspond to each other.

3. The storage device as claimed in claim 2, wherein, when the first training pattern and the second training pattern do not match each other, the target pattern and the second training pattern do not correspond to each other.

4. The storage device as claimed in claim 2 or claim 3, wherein
the storage controller (200) is further configured to:
adjust at least one of a delay or a voltage of a CA signal transmitted through the CA line in response to receiving the training failure signal from the memory device; and
transmit the first training pattern to the memory device (300_1) through the CA line, after adjusting at least one of the delay or the voltage of the CA signal, and
the memory device (300_1) is further configured to:
receive a third training pattern through the CA line in response to the storage controller (200) transmitting the first training pattern after adjusting at least one of the delay or the voltage of the CA signal; and
transmit a training success signal as the result signal to the storage controller in response to determining that the target pattern and the third training pattern correspond to each other.

5. The storage device as claimed in any of claims 1 - 4, wherein the memory device is further configured to transmit the result signal to the storage controller through the data line or the CA line.

6. The storage device as claimed in any of claims 1 - 5, wherein the memory device (300_1) further comprises:
a buffer (323) configured to store the received second training pattern and the target pattern;
a comparator circuit (324) configured to generate the result signal by comparing the second training pattern and the target pattern; and
a memory cell array comprising a plurality of memory cells and a system area configured to store the target pattern by using a part of the plurality of memory cells, and
wherein the memory device (300_1) is further configured to store the target pattern stored in the system area of the memory cell array in the buffer (323).

7. The storage device as claimed in any preceding claim, wherein the storage controller (200) is further configured to:
transmit a specific command to the memory device (300_1) through the CA line to request the memory device (300_1) to perform a specific operation; and
transmit the CA training command (S920) to the memory device (300_1) through the data line in response to a failure of the specific operation.

8. The storage device as claimed in any preceding claim, wherein
the storage device is configured to operate in one of a plurality of CA operation modes, the plurality of CA operation modes comprising a first CA operation mode and a second CA operation mode,
a speed at which the memory device (300_1) receives a plurality of CA signals through the CA line in the second CA operation mode is lower than a speed at which the memory device (300_1) receives the plurality of CA signals through the CA line in the first CA operation mode, and
the storage controller (200) is further configured to transmit the first training pattern to the memory device (300_1) through the CA line while the storage device operates in the first CA operation mode.

9. The storage device as claimed in any preceding claim, wherein
the storage device is configured to operate in one of a plurality of data operation modes, the plurality of data operation modes comprising a first data operation mode and a second data operation mode,
a speed at which the memory device (300_1) receives a plurality of data signals through the data line in the second data operation mode is lower than a speed at which the memory device (300_1) receives the plurality of data signals through the data line in the first data operation mode, and
the storage controller (200) is further configured to transmit the CA training command to the memory device (300_1) through the data line while the storage device operates in the second data operation mode.

10. The storage device as claimed in any preceding claim, wherein
the storage device is configured to perform an operation of training data received through the data line, and
the storage controller (200) is further configured to transmit the CA training command to the memory device (300_1) through the data line after the operation of training the data has been completed.

11. The storage device as claimed in any preceding claim, wherein the storage controller (200) is further configured to transmit a command and an address corresponding to the command to the memory device (300_1) through the CA line after the CA training operation has been completed.

12. An operating method of a storage device comprising a storage controller (200) comprising a first data pin and a first command/address, CA, pin and a memory device (300_1) comprising a second data pin connected to the first data pin through a data line and a second CA pin connected to the first CA pin through a CA line, the method comprising:
transmitting, by the storage controller (200), a CA training command (S920) to the memory device (300_1) through the data line to start a CA training operation;
transmitting, by the storage controller (200), a first training pattern (S930) to the memory device through the CA line;
receiving, by the memory device (300_1), the CA training command through the data line;
receiving, by the memory device (300_1), a second training pattern through the CA line in response to the storage controller (200) transmitting the first training pattern;
performing, by the memory device (300_1), the CA training operation using the second training pattern in response to receiving the CA training command;
transmitting, by the memory device, to the storage controller (200), a result signal indicating a result of performing the CA training operation based on the second training pattern and a target pattern stored in the memory device;
transmitting, by the memory device, a training success signal to the storage controller in response to determining that the target pattern and the second training pattern correspond to each other;
wherein, when the first training pattern and the second training pattern match each other, the target pattern and the second training pattern correspond to each other.
